# EUROPEAN PATENT SPECIFICATION

(11) **EP 3 422 833 B1**
(45) Date of publication and mention of the grant of the patent: **22.02.2023**
(21) Application number: 18176841.7
(22) Date of filing: 08.06.2018
(51) Int. Cl.: H05K 7/20

(54) **ARC SHAPE FRONT PANEL**
BOGENFÖRMIGE FRONTPLATTE
PANNEAU AVANT EN FORME D'ARC

(30) Priority: 30.06.2017 US 201762527273 P; 13.02.2018 US 201815895363
(43) Date of publication of application: 02.01.2019
(73) Proprietor: Quanta Computer Inc., Taoyuan City 333 (TW)
(72) Inventor: CHEN, Chao-Jung, Taoyuan City (TW); HUANG, Yu-Nien, Taoyuan City (TW); TAN, Herman, Taoyuan City (TW)
(74) Representative: D Young & Co LLP

(56) References cited:
- WO-A1-2013/050703
- US-A1- 2014 098 492
- US-A1- 2015 116 935

## Description

### FIELD OF THE INVENTION

The present invention relates to apparatuses for dissipating heat that emanates from individual electronic units housed within a server device.

### BACKGROUND

Most modern communications equipment includes heat generating electronic components that have to be cooled to enable them to function effectively. Typically, the electronic components are cooled using air that is forced into the equipment chassis to flow over the electronic components. In data center environments with large number of electronic components, thermal management can be a challenge. Some data centers utilize a hot aisle/cold aisle layout design for server racks and other computing equipment, to conserve energy and lower cooling costs by managing air flow effectively.

In its simplest form, hot aisle/cold aisle data center design involves lining up server racks in alternating rows with cold air intakes facing one direction, and hot air exhausts facing the opposite direction. The rows composed of rack fronts are called cold aisles. Typically, cold aisles face air conditioner output ducts. The rows, into which heated exhausts pour, are called hot aisles. Typically, hot aisles face air conditioner return ducts. Cool air thus enters at the front, and hot air exits at the back.

Equipment used in such hot aisle/cold aisle data centers may have front-to-back airflow cooling. For example, in a switch comprising a plurality of line cards, the air enters at a front panel faceplate of each individual line card (e.g., front panel being perpendicular to the length of the line card), passes through a mid-plane of the line card, and exits at the back of the switch chassis. The front panel can include vents, which permit air to enter the chassis. The perforation area can affect board-level (e.g., at the line card level) and system-level (e.g., at the switch chassis level) cooling. However, port density of the line-cards is already quite high, and expected to increase in the future. The increasing number of ports on the faceplate in consideration of the limited total exposed area of the faceplate presents a challenge in configuring the perforations on the front panel faceplate. Moreover, the power dissipation and cooling demands are increased proportional to the port density. However, with the increased port density, the perforation area is reduced. Thus, the cooling capacity of the line card is reduced.

The inability to remove this heat can result in accelerated aging and/or premature failure of the interconnection of other components. Therefore, there is a need to provide a cooling system in high speed communication devices that facilitates high-heat removal and dense packaging of the interconnections. US 2015/0116935 A1 discloses an electronic chassis base and a chassis cover which define an electronic enclosure. The chassis base includes a slant angle venting plate extending at an angle from a chassis base sidewall of the chassis base. The slant angle venting plate has a slant angle vent plate pattern formed therein. As the slant angle venting plate is slanted, the available surface area in which to form the slant angle vent plate pattern is maximized. US 2014/0098492 A1 discloses an apparatus that includes a faceplate having a plurality of slots arranged on a front portion of the faceplate. A channel may be disposed behind the faceplate and between a bottom surface of the top portion of the faceplate, a bottom surface of the top plate and a top surface of the screen. The screen may include a plurality of openings. Air may be guided through the slots by a fan operating behind the apparatus, along the channel and through the plurality of openings to one or more heat generating components on the line card. WO 2013/050703A1 discloses a piece of computer equipment which is to be irremovably inserted into a computer cabinet and connected to electronic devices having a four-sided contour with a first side, a second side opposite the first side, a third side and a fourth side opposite the third side, the third and fourth sides being separated from oone another by a predetermined distance.

### SUMMARY

Particular and preferred aspects of the present invention are set out in the accompanying independent and dependent claims.

Although many of the examples herein are described with reference to a switch device, it should be understood that these are only examples, and that the present disclosure is not limited in this regard. Rather, any electronic component installed within a computer data center can be implemented within the disclosed convex feature.

Additional features and advantages of the disclosure will be set forth in the description which follows, and in part, will be obvious from the description, or can be learned by practice of the herein disclosed principles. The features and advantages of the disclosure can be realized and obtained by means of the instruments and combinations particularly pointed out in the appended claims. These and other features of the disclosure will become more fully apparent from the following description and appended claims, or can be learned by the practice of the principles set forth herein.

### BRIEF DESCRIPTION OF THE DRAWINGS

In order to describe the manner in which the above-recited disclosure, and its advantages and features, can be obtained, a more particular description of the principles briefly described above will be rendered by reference to specific examples illustrated in the appended drawings. These drawings depict only example aspects of the disclosure and are not therefore to be considered to be limiting of its scope. The principles are described and explained with additional specificity and detail through the use of the following drawings.
FIG. 1A shows a perspective view of a prior art computer device, exemplified without a cover to illustrate the internal components;
FIG. 1B shows a perspective view of a prior art computer device, exemplified with a cover;
FIG. 2 shows a front view of computing device implementing a convex faceplate according to one or more embodiments of the disclosure;
FIG. 3 shows a top view of the switch of FIG. 2, according to one or more embodiments of the disclosure;
FIG. 4 illustrates a plurality of switches assembled parallel to each other in a chassis, according to one or more embodiments of the disclosure;
FIG. 5 is a top view of the switch of FIG. 2 exemplifying the I/O connectors, according to one or more embodiments of the disclosure;
FIG. 6 is a top view of the switch of FIG. 2 exemplifying the I/O connectors and a chipset, according to one or more embodiments of the disclosure; and
FIGs. 7A and 7B are diagrams exemplifying the improvement in signal strength corresponding with the proximity of the I/O connectors to the chipset.

### DETAILED DESCRIPTION

The present invention is described with reference to the attached figures, wherein like reference numerals are used throughout the figures to designate similar or equivalent elements. The figures are not drawn to scale, and they are provided merely to illustrate the instant invention. Several aspects of the invention are described below with reference to example applications for illustration. It should be understood that numerous specific details, relationships, and methods are set forth to provide a full understanding of the invention.

In general, one implementation of the subject matter disclosed herein is directed to a cooling assembly for cooling electronic devices within a rack server. In one or more implementations, the convex shaped faceplate offers an additional cross section to be utilized to increase airflow. The faceplate includes multiple vent holes for airflow. Thus, cooling, according to one or more implementations, occurs within the electronic device. The effectiveness of this technique can be enhanced by increasing the number of airflow vent holes and/or by increasing the angle of the faceplate to increase the surface area.

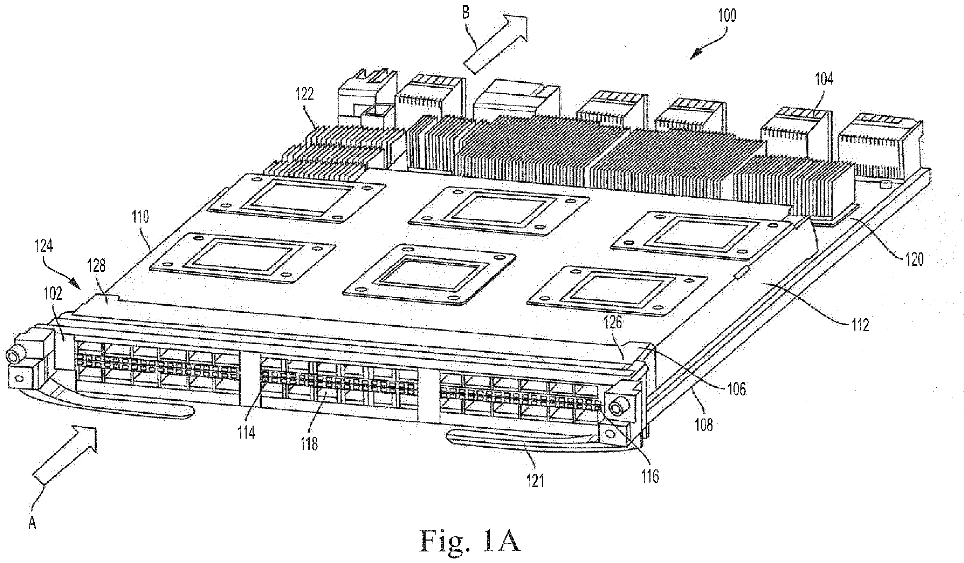

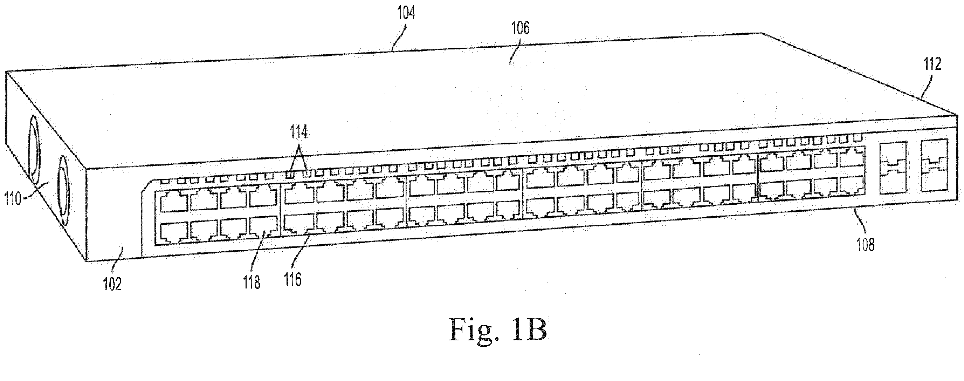

FIG. 1A illustrates a perspective view of a switch 100 of the prior art. The switch 100 may be one of a plurality of switches stacked in and supported by a chassis (not shown). The switch 100 includes a front 102, a back 104, a top 106, a bottom 108, a first side 110, and a second side 112. As shown in FIG. 1A, the switch 100 does not include a cover, as the chassis may act as a cover when the switch 100 is installed in the chassis. In another embodiment shown in FIG. 1B, the switch 100 includes a cover that surrounds any combination of the front 102, the back 104, the top 106, the bottom 108, the first side 110, and the second side 112.

Referring back to FIG. 1A, the front 102 of the switch 100 includes a plurality of openings 114 (e.g., vent holes) through which air used to cool the switch 100 flows. The front 102 also includes a plurality of openings 116 for corresponding I/O connectors 118, for example.

In some embodiments, the switch 100 includes any number of components including, for example, the I/O connectors 118, a plurality of heat generating electrical hardware components 120, a plurality of fans (not shown), a plurality of baffles (not shown), and other thermal management components (e.g., heat pipes). The I/O connectors 118, the plurality of heat generating electrical hardware components, the plurality of fans, the plurality of baffles, the other thermal management components, or a combination thereof may be supported by and/or attached to the bottom 108. The various components, or a combination thereof, can be attached to the bottom 108 by using an adhesive, screws, nut/bolt combinations, snaps, mated press fittings, other attachment devices, or a combination thereof. The switch 100 may include different, additional, or fewer components. For example, the switch 100 includes one or more rotatable levers 121 operable to lock the switch 100 in the chassis.

The I/O connectors 118 may be any number of I/O connectors 118 including, for example, RJ45 connectors or SFP connectors. The I/O connectors 118 may be used for input only, output only, or both input and output connections.

The plurality of heat generating electric hardware components 120 may include heat sinks 122 to aid in the transfer of heat from the plurality of heat generating electric hardware components 120 to the surrounding air. The plurality of heat generating electric hardware components 120 may include, for example, processors, circuits, transistors, memory devices, power supplies, transformers, chips, integrated circuits, or other electronics.

The plurality of fans pull or push (e.g., depending on the direction the plurality of fans are positioned within the switch 100) air into or out of the plurality of openings 114. In one embodiment, air is pulled into the switch 100 through the plurality of openings 114 in the direction of arrow A. At least a portion of the air is pushed out of the switch 100 at the back 104, as indicated by arrow B. In another embodiment, the flow of air is reversed, as air is pulled into the switch 100 at the back 104, and pushed out of the switch 100 through the plurality of openings 114 at the front 102.

The front 102 of the switch 100 may be formed by a faceplate 124. The faceplate 124 includes the plurality of openings 114 for airflow and the plurality of openings 116 for the I/O connectors 118. The faceplate 124 may be attached to the switch 100 in any number of ways. For example, the faceplate 124 may be attached to the switch 100 with a plurality of fasteners 126 at one or more flanges 128 of the faceplate 124. The plurality of fasteners 126 may include, for example, screw/tapped screw hole or nut/bolt combinations, but other connections such as snap or press fits or rivets may also be used.

The plurality of openings 114 are provided for thermal management purposes. Depending on the number of I/O connectors 118 and thus the size of the openings 116 provided for the I/O connectors 118 of the switch 100, there may be little space remaining for placement of the plurality of openings 114. Thus, there is a tradeoff between the number of plurality of openings 114 and the number of I/O connectors 118. For example, the more I/O connectors 118 present within the faceplate 124, the less space is available within the faceplate 124 for vent holes. Conversely, you can provide more vent holes, as indicated in FIG. 1A, but lose space for the I/O connectors 118. This is kind of an important point we should be discussing. Additionally, the increased surface area allows for a greater spacing between components, which can also facilitate cooling.

For high power consumption switches or line cards, temperatures of one or more of the heat generating electrical hardware components during operation of the switch may be too great without sufficient airflow through the switch or line card to cool the heat generating electrical hardware components. The switch or line card may not operate properly and/or may shut down with such high temperatures. If the openings 114 are made too large and/or positioned too close together, the openings 114 may cause electro-magnetic interference and/or structural integrity issues. As indicated herein, the faceplate 124 is flat with respect to the front 102 of the switch 100.

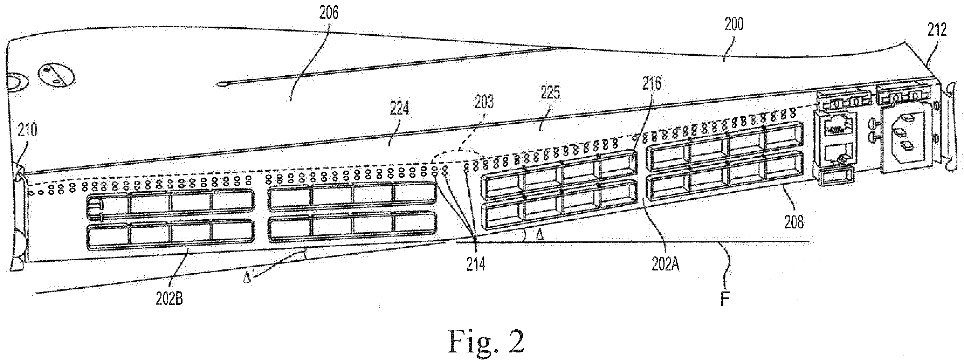

FIG. 2 illustrates a perspective view of one embodiment of a switch 200. The switch 200 includes a front 202 (202 is not shown in Fig. 2), a back (not shown), a top 206, a bottom 208, a first side 210, and a second side 212. The front 202 of the switch 200 includes a plurality of openings 214 (e.g., vent holes) through which air used to cool the switch 200 flows. The front 202 also includes a plurality of openings 216 for corresponding I/O connectors (not shown), for example. The front 202 of the switch 200 may be formed by a convex shaped faceplate 224. In the current embodiment, the convex faceplate 224 includes a triangular shape with an angle measuring less than 180°. In some embodiments, other shapes may be implemented. For example, although a triangular shape is indicated herein, a curved faceplate, a trapezoid faceplate or any other type of convex polygon can be implemented.

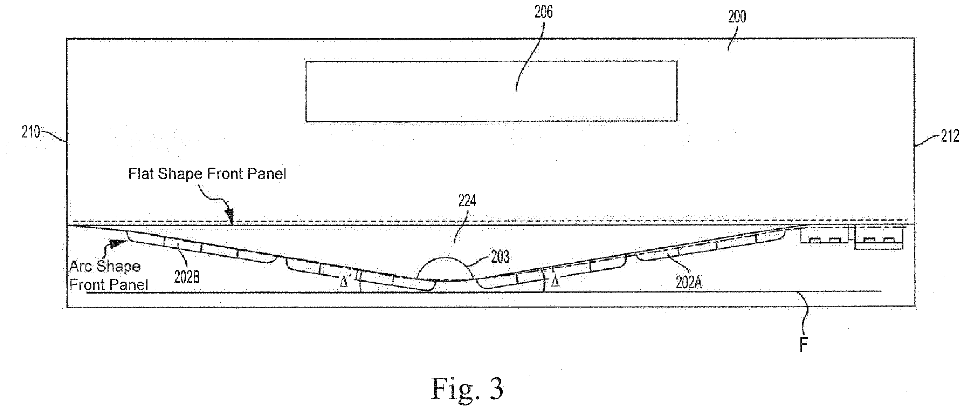

The convex faceplate 224 includes front side (face) 202A angled towards a front side F, which is a virtual front side, at an angle Δ. The convex faceplate 224 also includes front side (face) 202B angled towards the front side F at an angle Δ'. The faceplate 224 also includes a top panel 225 disposed on the top side of faceplate 224. The top panel 225 is attached to the front sides 202A and 202B to create an angled portion 203. The angled portion 203 is an obtuse angle, representing the convex shape of the faceplate 224. In various embodiments, the angled portion 203 of the top panel 225 and the front sides 202A and 202B facilitate an intake area for air flow between switch 200 and other parallel line cards assembled on a chassis (discussed below in greater detail). In some embodiments, the faceplate 224 is removably attached to the switch 200, for example, using suitable screws or nuts and bolts. FIG. 3 shows a top view of one embodiment of the switch 200.

In various embodiments, the faceplate 224 may be manufactured using existing manufacturing processes, such as extrusion. It should be understood that other manufacturing methods can be implemented herein. For example, the face plate material can be made from plastic material. In a general sense, extrusion is a generally known manufacturing process in which a material is pushed or drawn through a die of a desired cross-section. Extrusion may be continuous (e.g., producing long material of intricate shape) or semi-continuous (e.g., producing many pieces, each of intricate shape). The extrusion process can be done with hot or cold material. In various embodiments, the material used for faceplate 224 may comprise aluminum. Note that any suitable manufacturing material can be used within the broad scope of the embodiments, for example, any metallic, plastic or even wood material can be implemented herein. The plurality of openings 214 can be formed using a CNC milling machine or using any other process suitable for creating such openings.

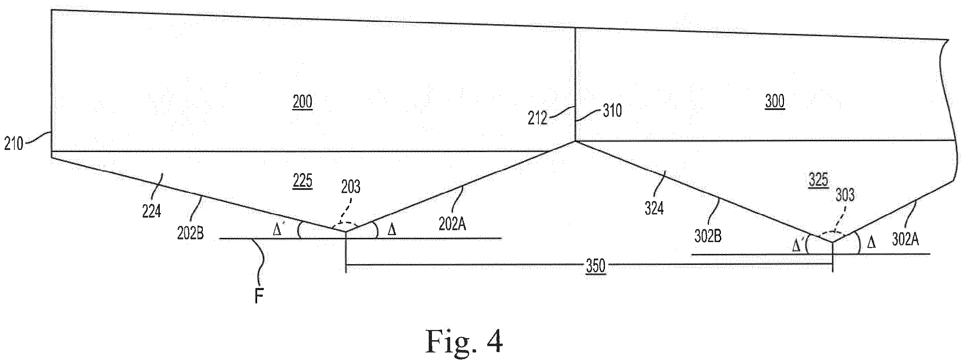

FIG. 4 illustrates a plurality of switches assembled parallel to each other in a chassis. The switch 200 includes a first side 210 and a second side 212. The switch 200 also includes a convex faceplate 224. The convex faceplate 224 includes front side (face) 202A angled towards the front side F at an angle Δ. The convex faceplate 224 also includes front side (face) 202B angled towards the front side F at an angle Δ'. The faceplate 224 also includes a top panel 225 disposed on the top side of faceplate 224. The top panel 225 is attached to the front sides 202A and 202B to create an angled portion 203. The switch 300 includes a first side 310 that abuts the second side 212 of the switch 200. (The second side of the switch 300 is not visible in FIG. 4.) The switch 300 can also include a convex faceplate 324. The convex faceplate 324 includes front side (face) 302A angled towards the front side F at an angle Δ. The convex faceplate 324 also includes front side (face) 302B angled towards the front side F at an angle Δ'. The faceplate 324 also includes a top panel 325 disposed on the top side of faceplate 324. The top panel 325 is attached to the front sides 302A and 302B to create an angled portion 303.

In various embodiments, a channel 350 for air flow is disposed between the faceplate 224 of the switch 200 and the faceplate 324 of the switch 300. In particular embodiments, angled portions 203 and 303 of the top panels 225 and 325 facilitate an intake area of the channel 350. The channel 350 increases the airflow along the front sides 202A and 302B. In some embodiments, the first side 210 of switch 200 may also abut another switch creating another channel for air flow along the front side 202B. Similarly, the second side of switch 300 (not shown) may also abut another switch creating another channel for air flow along the front side 302A.

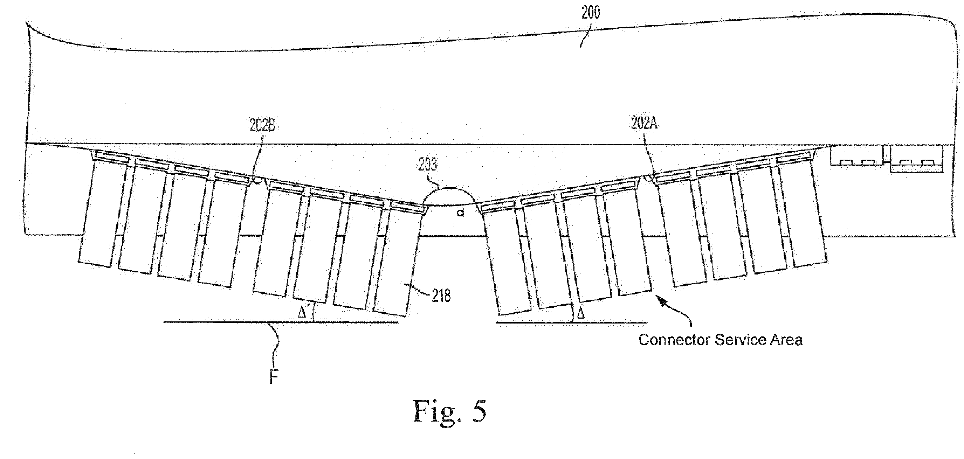

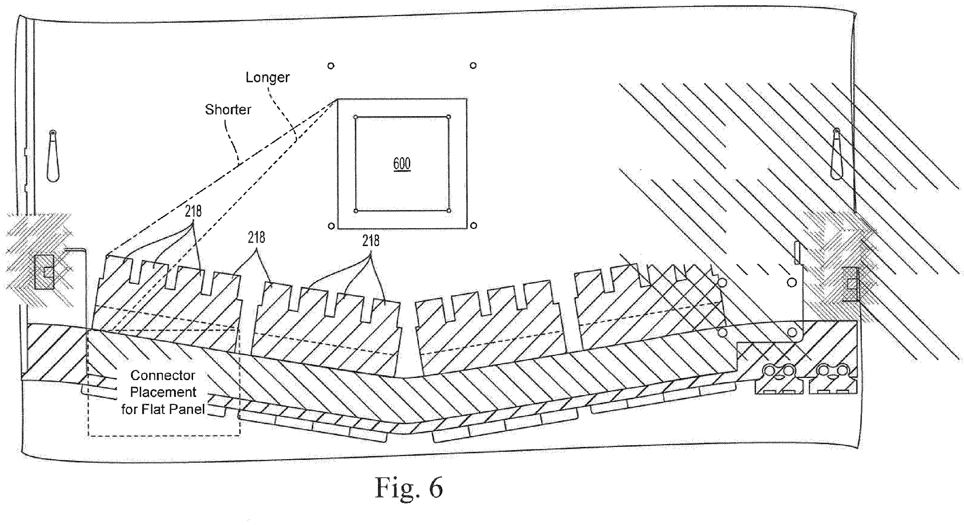

FIG. 5 is a top view of one embodiment of the switch 200 exemplifying the I/O connectors 218. The I/O connectors 218 may be any number of I/O connectors 218 including, for example, RJ45 connectors or SFP connectors. The I/O connectors 218 may be used for input only, output only, or both input and output connections. The I/O connectors 218 are positioned within front sides 202B and 202A. Thus, the I/O connectors 218 are also angled towards the front side F at an angle Δ' and Δ. The positioning of the I/O connectors 218 along front sides 202B and 202A, at an angle Δ' and Δ, creates additional space to include more I/O connectors 218. Furthermore, the positioning of the I/O connectors 218 along front sides 202B and 202A, at an angle Δ' and Δ, assists in improving signal integrity of the connector. This is discussed in greater detail below with respect to FIG. 6.

FIG. 6 is a top view of one embodiment of the switch 200 exemplifying the I/O connectors and a chipset 600. The switch 200 includes a chipset 600 which includes switches (not shown) and a chip (not shown). As shown, chipset 600 is arranged to support ports associated I/O connectors 218. The I/O connectors 218 are also angled towards the front side F at an angle Δ' and Δ. Thus, the distance between the I/O connectors 218 and the chipset 600 is reduced. Because the I/O connectors 218 are placed physically closer to the chipset 600, the signal integrity of the connector can be improved.

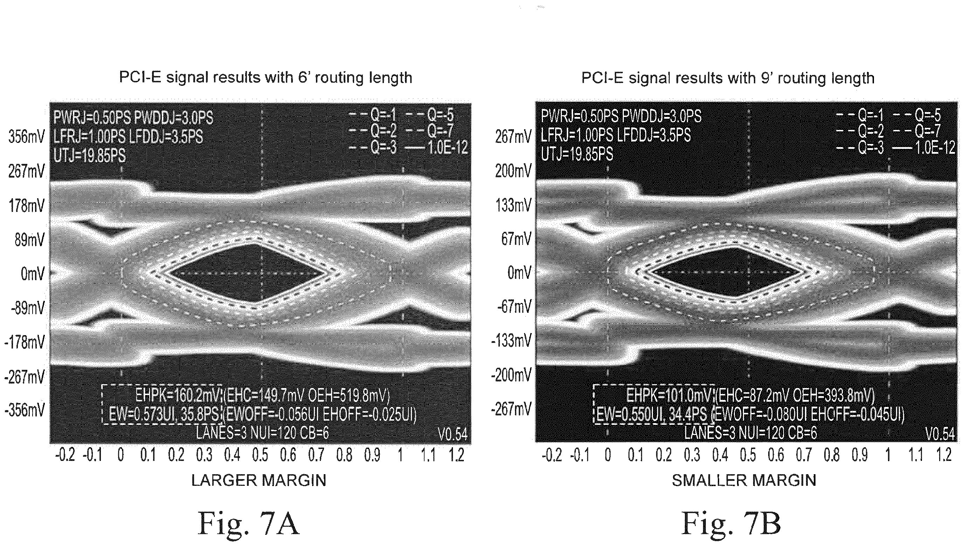

FIG. 7A and 7B are diagrams exemplifying the improvement in signal strength corresponding with the proximity of the I/O connectors to the chipset. FIG. 7A and 7B illustrates an exemplary 6 and 9 inches of routing length, respectively. FIG. 7B exemplifies the PCI-E signal results where the routing length to the chipset is 9 inches. When the routing length is 9 inches, the ehpk measures to be 101.0 mV. Furthermore, when the routing length is 9 inches, the ew = 0.550UI, and 34.4ps. The signal strength improves when the routing length is shortened to 6 inches. FIG. 7A exemplifies the PCI-E signal results where the routing length to the chipset is 6 inches. For example, the ehpk measures to 160.2 mV. Furthermore, the ew = 0.573UI, and 35.8ps.

The terminology used herein is for the purpose of describing particular embodiments only and is not intended to limit the appended claims.

As used herein, the singular forms "a", "an", and "the" are intended to include the plural forms as well, unless the context clearly indicates otherwise. Furthermore, to the extent that the terms "including", "includes", "having", "has", "with", or variants thereof are used in either the detailed description and/or the claims, such terms are intended to be inclusive in a manner similar to the term "comprising."

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art, and will not be interpreted in an idealized or overly formal sense unless expressly so defined herein.

Although particular embodiments have been described herein, it will be appreciated that the invention is not limited thereto and that many modifications and additions thereto may be made within the scope of the appended claims.

## Claims

1. An apparatus comprising:
a switch (200/300); and
a fan disposed towards a back side of the apparatus;
wherein the switch (200/300) comprises a faceplate (224,324) having a plurality of openings (216) for corresponding I/O connectors (218) and comprising:
a top panel (225/325) including a portion (203/303) angled towards a front side (F) of the faceplate (224/324), the angled portion (203/303) comprising an obtuse angle; and
a front panel (202) disposed on the front side (F) of the faceplate (224/324), the front panel comprising a first face (202A/302A) angled towards the front side (F) of the faceplate (224/324) and a second face (202B/302B) angled towards the front side of the faceplate (224/324), the first face (202A/302A) and the second face (202B/302B) having a plurality of holes (214), wherein the angled portion (203/303) of the top panel (225/325), the angled first face (202A/302A), and the angled second face (202B/302B) facilitate an intake/outlet area for air flow across the front side of the faceplate, **characterised in that** the apparatus further comprises a chassis, wherein each of the openings (216) are equal distance to a chipset (600) located at the chassis.

2. The apparatus of claim 1, **characterized in that** the angled portion (203/303) of the top panel (225/325), the angled first face (202A/302A) and the angled second face (202B/302B) facilitate the intake/outlet area for air flow across the apparatus.

3. The apparatus of any preceding claim, **characterized in that** the I/O connectors (218) are angled towards the front side (F) of the faceplate (224/324).

4. The apparatus of any preceding claim, **characterized in that** the faceplate (224/324) is removably attached to the switch (200/300).

5. The apparatus of any preceding claim, **characterized in that** the faceplate (224/324) is manufactured using extrusion.

6. The apparatus of any preceding claim, **characterized in that** a channel (350) for air flow is disposed between the first face (202A/302A) and the second face (202B/302B) of the faceplate (224/324) of the switch (200/300).

7. The apparatus of any preceding claim, **characterized in that** the fan is disposed in the switch (200/300) towards a back of the apparatus, wherein when the fan operates, air is pulled in through the channel (350) from the front of the faceplates (224/324) and is forced over one or more heat generating components in the switch (200/300).

## Patentansprüche

1. Vorrichtung, umfassend:
einen Switch (200/300) und
einen zu einer Rückseite der Vorrichtung hin angeordneten Lüfter,
wobei der Switch (200/300) eine Frontplatte (224, 324) mit einer Vielzahl von Öffnungen (216) für entsprechende I/O-Stecker (218) umfasst, und umfassend:
eine obere Platte (225/325), die einen zu einer Vorderseite (F) der Frontplatte (224/324) hin abgewinkelten Abschnitt (203/303) aufweist, wobei der abgewinkelte Abschnitt (203/303) einen stumpfen Winkel umfasst, und
eine vordere Platte (202), die an der Vorderseite (F) der Frontplatte (224/324) angeordnet ist, wobei die vordere Platte eine erste Fläche (202A/302A), die zu der Vorderseite (F) der Frontplatte (224/324) abgewinkelt ist, und eine zweite Fläche (202B/302B), die zu der Vorderseite der Frontplatte (224/324) abgewinkelt ist, umfasst, wobei die erste Fläche (202A/302A) und die zweite Fläche (202B/302B) eine Vielzahl von Löchern (214) haben, wobei der abgewinkelte Abschnitt (203/303) der oberen Platte (225/325), die abgewinkelte erste Fläche (202A/302A) und die abgewinkelte zweite Fläche (202B/302B) einen Einlass-/Auslassbereich für Luftströmung über die Vorderseite der Frontplatte bereitstellen, **dadurch gekennzeichnet, dass** die Vorrichtung ferner ein Chassis umfasst, wobei jede der Öffnungen (216) in gleichem Abstand zu einem an dem Chassis angeordneten Chipsatz (600) angeordnet sind.

2. Vorrichtung nach Anspruch 1, **dadurch gekennzeichnet, dass** der abgewinkelte Abschnitt (203/303) der oberen Platte (225/325), die abgewinkelte erste Fläche (202A/302A) und die abgewinkelte zweite Fläche (202B/302B) den Einlass-/Auslassbereich für Luftströmung über die Vorrichtung bereitstellen.

3. Vorrichtung nach einem der vorhergehenden Ansprüche, **dadurch gekennzeichnet, dass** die I/O-Stecker (218) zu der Vorderseite (F) der Frontplatte (224/324) hin abgewinkelt sind.

4. Vorrichtung nach einem der vorhergehenden Ansprüche, **dadurch gekennzeichnet, dass** die Frontplatte (224/324) entfernbar an dem Switch (200/300) angebracht ist.

5. Vorrichtung nach einem der vorhergehenden Ansprüche, **dadurch gekennzeichnet, dass** die Frontplatte (224/324) unter Verwendung von Strangpressen hergestellt ist.

6. Vorrichtung nach einem der vorhergehenden Ansprüche, **dadurch gekennzeichnet, dass** ein Kanal (350) für Luftströmung zwischen der ersten Fläche (202A/302A) und der zweiten Fläche (202B/302B) der Frontplatte (224/324) des Switch (200/300) angeordnet ist.

7. Vorrichtung nach einem der vorhergehenden Ansprüche, **dadurch gekennzeichnet, dass** der Lüfter in dem Switch (200/300) zu einer Rückseite der Vorrichtung hin angeordnet ist, wobei Luft bei Betrieb des Lüfters durch den Kanal (350) von der Vorderseite der Frontplatten (224/324) eingesaugt und über eine oder mehrere wärmeerzeugende Komponenten in dem Switch (200/300) zwangsgeführt wird.

## Revendications

1. Appareil comprenant :
un commutateur (200/300) ; et
un ventilateur disposé vers un côté arrière de l'appareil ;
le commutateur (200/300) comprenant une plaque frontale (224, 324) ayant une pluralité d'ouvertures (216) pour des connecteurs E/S (218) correspondants et comprenant :
un panneau supérieur (225/325) comprenant une partie (203/303) inclinée vers un côté avant (F) de la plaque frontale (224/324), la partie inclinée (203/303) comprenant un angle obtus ; et
un panneau avant (202) disposé sur le côté avant (F) de la plaque frontale (224/324), le panneau avant comprenant une première face (202A/302A) inclinée vers le côté avant (F) de la plaque frontale (224/324) et une seconde face (202B/302B) inclinée vers le côté avant de la plaque frontale (224/324), la première face (202A/302A) et la seconde face (202B/302B) ayant une pluralité de trous (214), la partie inclinée (203/303) du panneau supérieur (225/325), la première face inclinée (202A/302A) et la seconde face inclinée (202B/302B) créant une zone d'entrée/sortie pour un écoulement d'air à travers le côté avant de la plaque frontale, **caractérisé en ce que** l'appareil comprend en outre un châssis, chacune des ouvertures (216) étant à distance égale d'un jeu de puces (600) situé au niveau du châssis.

2. Appareil selon la revendication 1, **caractérisé en ce que** la partie inclinée (203/303) du panneau supérieur (225/325), la première face inclinée (202A/302A) et la seconde face inclinée (202B/302B) créent la zone d'entrée/sortie pour l'écoulement d'air à travers l'appareil.

3. Appareil selon l'une quelconque des revendications précédentes, **caractérisé en ce que** les connecteurs E/S (218) sont inclinés vers le côté avant (F) de la plaque frontale (224/324).

4. Appareil selon l'une quelconque des revendications précédentes, la plaque frontale (224/324) étant fixée de manière amovible au commutateur (200/300).

5. Appareil selon l'une quelconque des revendications précédentes, **caractérisé en ce que** la plaque frontale (224/324) est fabriquée par extrusion.

6. Appareil selon l'une quelconque des revendications précédentes, **caractérisé en ce qu'**un canal (350) pour l'écoulement d'air est disposé entre la première face (202A/302A) et la seconde face (202B/302B) de la plaque frontale (224/324) du commutateur (200/300).

7. Appareil selon l'une quelconque des revendications précédentes, **caractérisé en ce que** le ventilateur est disposé dans le commutateur (200/300) vers l'arrière de l'appareil, lorsque le ventilateur fonctionne, l'air étant aspiré à travers le canal (350) depuis l'avant des plaques frontales (224/324) et étant forcé sur un ou plusieurs composants générateurs de chaleur dans le commutateur (200/300).
